# EUROPEAN PATENT SPECIFICATION

(11) **EP 0 490 320 B1**
(45) Date of publication and mention of the grant of the patent: **11.09.1996**
(21) Application number: 91121093.8
(22) Date of filing: 09.12.1991
(51) Int. Cl.: G02B 5/18, G03F 7/00

(54) **A method for producing a diffraction grating**
Verfahren zur Herstellung eines Beugungsgitters
Méthode pour la production d'un réseau de diffraction

(30) Priority: 10.12.1990 JP 409794/90
(43) Date of publication of application: 17.06.1992
(73) Proprietor: CANON KABUSHIKI KAISHA, Tokyo (JP)
(72) Inventor: Ohguri, Noriaki, c/o Canon Kabushiki Kaisha, Ohta-ku, Tokyo (JP)
(74) Representative: Bühling, Gerhard, Dipl.-Chem.

(56) References cited:
- JP-A-60 191 209
- US-A- 3 733 258
- US-A- 4 241 109
- US-A- 4 321 282
- US-A- 4 895 790
- PATENT ABSTRACTS OF JAPAN vol. 11, no. 42 (P-545)6 February 1987 & JP-A-61 212803
- PATENT ABSTRACTS OF JAPAN vol. 12, no. 413 (P-780)2 February 1988 & JP-A-63 149 603

## Description

### BACKGROUND OF THE INVENTION

### Field of the Invention

This invention relates to a method of producing a diffraction grating, and more particularly, to a method of producing a diffraction grating having a very fine period or pitch for use in various devices such as filters and semiconductor lasers.

### Related Background Art

Diffraction gratings have been used in opto-electronic fields, as various optical circuit devices such as filters, optical couplers, distributed feedback (DFB) type lasers, distributed Bragg reflection (DBR) type lasers and the like. In particular, diffraction gratings formed in tunable or wavelength changeable lasers typified by DFB and DBR lasers are used as resonators of lasers, and hence the pitch, shape and depth thereof are critical factors for determining characteristics of the laser such as its oscillation threshold and its coupling coefficient. Therefore, it is a key technique to fabricate a highly precise diffraction grating with excellent controllability in such laser.

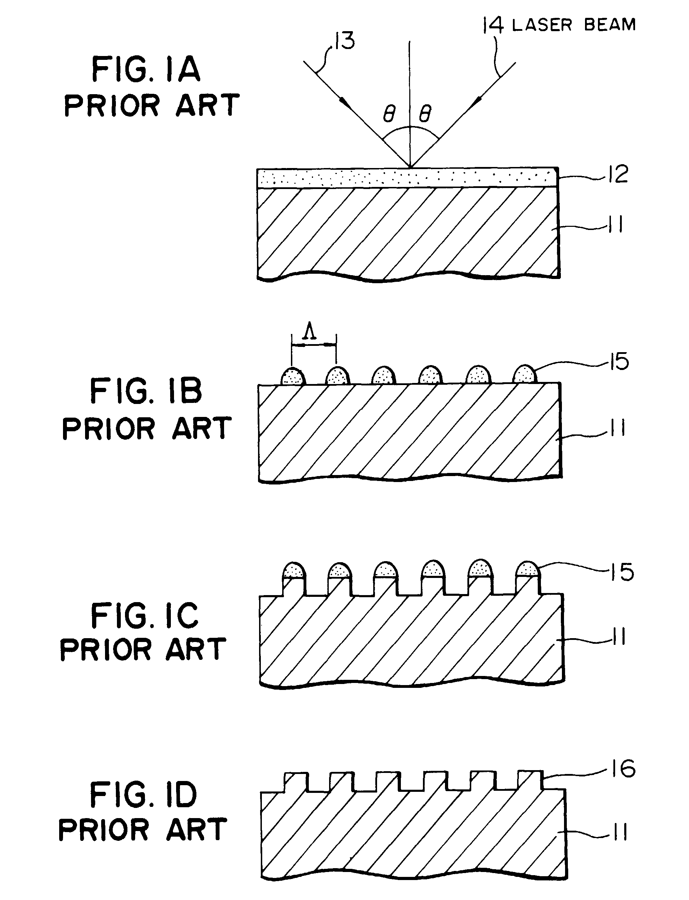

Conventionally, the fabrication of diffraction gratings has been conducted by a two-step process including a step of producing a grating-shaped photoresist mask and a step of etching. Since the pitch of diffraction gratings in the opto-electronic fields is fine, for example. 0.1∼1.0 µ m, a conventional photolithographic technique could not be utilized for forming the photoresist mask. Thus, a holographic exposure method has been generally used. This method is an exposure method using an interference of laser beams. Figs. 1A to 1D illustrate the process.

In this method, initially, a photoresist 12 is applied to a substrate 11 as shown in Fig. 1A. Two laser beams 13 and 14 are projected from two directions with each beam forming an angle θ for a perpendicular line to the surface of the substrate 11, in order to form interference fringes in the photoresist 12. The photoresist 12 is thus periodically exposed according to the pattern of the interference fringes. A diffraction-shaped photoresist mask 15 is produced by developing and baking the exposed photoresist 12 on the substrate 11.

Next, the etching (wet or dry) is conducted as shown in Fig. 1C with the photoresist mask 15 functioning as an etching mask. Then, a periodic structure (diffraction grating) 16 is transferred to the substrate 11 as shown in Fig. 1D by removing the photoresist mask 15.

In the holographic interferometry exposure method, a grating pitch Λ to be formed (see Fig. 1B) is represented by Λ = λ/2 sinθ where the incident angle of two laser beams is θ and the wavelength thereof is λ. As a laser for exposure use, an Ar laser ( λ =351 nm) and an He-Cd laser ( λ=325 nm) are appropriate. The He-Cd laser is used for producing a photoresist mask of Λ ≦ 0.25 µm.

On the other hand, the oscillation wavelength λ of DFB and DBR semiconductor lasers can be represented by λ = λ ₒ/N_{eff} =2Λ/m (m=1,2,···). Here, λₒ/N_{eff} is a Bragg wavelength in medium. N_{eff} is an equivallent refractive index of medium and Λ is a pitch of the diffraction grating in the semiconductor laser. Where m=1, a first order diffraction is indicated, and in the case of m=2, a second order diffraction is indicated.

In such semiconductor laser having an active layer of, for example, GaAs for radiating a short wavelength light, the pitch Λ of its diffraction grating becomes as small as about 1150 Å (0.115 µm), obtained from the above-mentioned equation λ = λₒ/N_{eff} = 2Λ/m by substituting 0.8 µm into the oscillation wavelength λₒ and 1 into m (i.e., the first order diffraction is considered). Even if the m-th order diffraction is utilized, the pitch Λ only becomes m-times 1150 Å at most. Therefore, the diffraction grating of the first order could not be made in air even if the He-Cd laser of a wavelength of λ =3250 Å (325 nm) is used in order to lessen the wavelength of a laser beam for exposure use at the time of production of the diffraction grating.

Hence, several other methods have been proposed for producing a first order diffraction grating (its pitch Λ =1300 Å or less) of short wavelength DFB and DBR semiconductor lasers of GaAs series, and the following three are typical:

In a first method, a sample is immersed into a medium having a large refractive index, and an interference exposure is conducted therein to shorten the pitch of a diffraction grating by an amount equivalent to the refractive index of such medium. As a medium having a large refractive index, for example, xylene having a small light absorption factor is used. In a similar method, a triangle or rectangular prism is put on a photoresist film through oil for regulation of a refractive index and two light beams for exposure are caused to be incident on both sides of the prism.

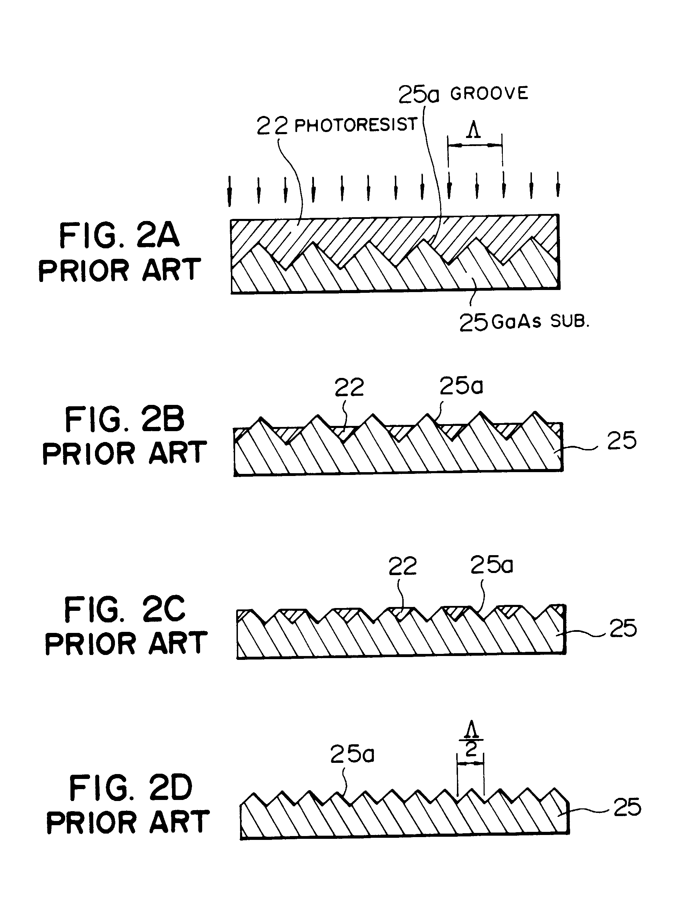

In a second method, a diffraction grating is produced by a two-beam interference exposure method and then the pitch (Λ) of the thus produced diffraction grating is halved by the following process: As shown in Fig. 2A, a multitude of grooves (grating) 25a on a substrate 25 and then an etching mask material or photoresist mask 22 is coated thereover. Next, as shown in Fig. 2B, the etched surface is exposed to light and developed. Thereafter, the etching is performed as shown in Fig. 2C, and as a result, a diffraction grating whose pitch is half that of pitch (Λ) of the groove 25a is obtained.

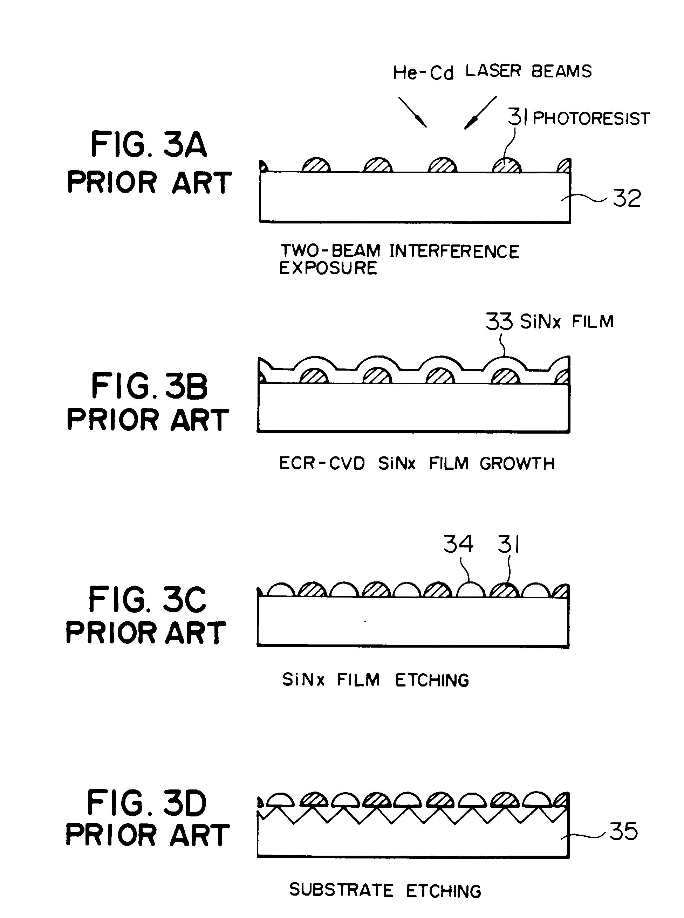

In a third method, a photoresist mask 31 is first formed on a substrate 32 by the two-beam interference exposure method (see Fig. 3A). Next, an SiNₓ film 33 is grown thereon by an electron cyclotron resonance-chemical vapor deposition (ECR-CVD) method (see Fig. 3B). Thereafter, an etching mask composed of photoresist 31 and SiNₓ film 34 is formed by regulating the etching time (see Fig. 3C). Then, the etching is performed using the mask 31 and 34 to form a grating 35 whose pitch is half that of the initially formed photoresist mask 31 (see Fig. 3D).

However, the above-discussed methods for fabricating a first order diffraction grating (a pitch Λ=1300 Å or less) of short wavelength ( λ =0.8 µm) DFB and DBR semiconductor lasers have the following disadvantages:

In the first method, drawbacks exist in that the light wave front of light for exposure is disturbed due to the scattering resulting from liquid, its container and so forth and due to the multiple reflection. Additionally, the vibration of the associated apparatus and the fluctuation of air have adverse influences. Thus, the accuracy of the diffraction grating is degraded.

In the second method, the control of exposure and development conditions to be conducted after the photoresist film 22 is formed as the etching mask should be strict, but is likely to be irregular. Thus, the accuracy of the diffraction grating is lowered. Moreover, if a wet etching is used at the time of the second etching. the surface orientation of the substrate 25 is restricted and the regularity of the diffraction grating shape is degraded.

In the third embodiment, it is difficult to control the etching conditions of the SiNₓ film 33 on the resist 31 and the substrate 32. Moreover, in the case of wet etching, the surface orientation of the substrate 32 is limited at the time of etching. In the case of dry etching, since the etching mask involves the two kinds of materials of resist 31 and SiNₓ film 34, their resistivities to etching gas differ from each other and the shape of the diffraction grating is likely to be irregular. Thus, the accuracies of depth and size thereof are lowered.

The US-4 321 282 discloses a process of forming a diffraction grating the steps of which are set forth in the preamble of claim 1. In this document, however, the exposure of the crests of projections and thereabout portions of the first diffraction grating is effected by grazing ion beam etching (Fig. 9 of this document). Subsequent to the grazing ion etching, conventional etching is effected to form the second diffraction grating (Fig. 10 of this document).

In the Japanese Patent Application No. 59-46910 a method for producing a diffraction grating is suggested, wherein after formation of a first diffraction grating a photoresist is coated on said first diffraction grating and a second diffraction grating having a pitch different from that of the first diffraction grating is obtained by etching using said photoresist as a mask.
However, in coating of the photoresist on the first diffraction grating another process is necessary for exposing merely the projections of the first diffraction grating.

In US Patent No. 4,241,109, after formation of a first diffraction grating a further mask is formed, wherein the mask is thicker on the projections of the first diffraction grating than on the recesses in order to obtain a diffraction grating having a high aspect ratio.

In US Patent No. 3,733,258 a photoresist is covered on a substrate, subsequently, the pattern of a hologramme is recorded in said photoresist, which is then transferred to the substrate by a sputter etching technique.

### SUMMARY OF THE INVENTION

An object of the present invention is to provide a method for forming a minute diffraction grating such as a first order diffraction grating of short wavelength ( λ = 0.8 µm) DFB and DBR lasers and the like, which is achieved by improving the above-mentioned second method.

This object is solved by the method of producing a diffraction grating according to claim 1.

According to the present invention, there are the steps of: forming a diffraction grating having a first pitch, coating the diffraction grating with material different from that of the grating, and forming a diffraction grating having a second pitch different from the first pitch by an etching process which includes a simultaneous etching of the material and the diffraction grating having the first pitch.

More concretely, the second pitch is half that of the first pitch; the step of forming the diffraction grating having the first pitch includes a step of applying a photoresist on a substrate, a step of interference-exposing the photoresist and a step of performing a first etching with the interference-exposed photoresist being a mask to form the diffraction grating having the first pitch; the different coating material coated on the diffraction grating is a photoresist; and the simultaneous etching comprises a step of performing a dry etching of the entire surface as a second etching.

In the diffraction grating producing method according to the present invention, since there are no light exposure and development steps after the different material such as the photoresist is coated on the diffraction grating, the process can be shortened and, in the case of a dry etching, the irregularity of the shape of the diffraction grating can be eliminated. Moreover, if the simultaneous etching is performed by a dry etching, the restriction of the surface orientation of the substrate and the irregularity of the shape will be eliminated. Therefore, the stability in pattern accuracy of the diffraction grating is improved and the yield is increased.

These advantages and others will be more readily understood in connection with the following detailed description, claims and drawings.

### BRIEF DESCRIPTION OF THE DRAWINGS

Figs. 1A-1D are cross-sectional views for illustrating steps of a diffraction grating forming method according to a prior art holographic interferometry method.

Figs. 2A-2D are cross-sectional views for illustrating steps of a second prior art diffraction grating forming method.

Figs. 3A-3D are cross-sectional views for illustrating steps of a third prior art diffraction grating forming method.

Figs. 4A-4E are cross-sectional views for illustrating steps of a first embodiment according to the present invention.

### DESCRIPTION OF THE PREFERRED EMBODIMENT

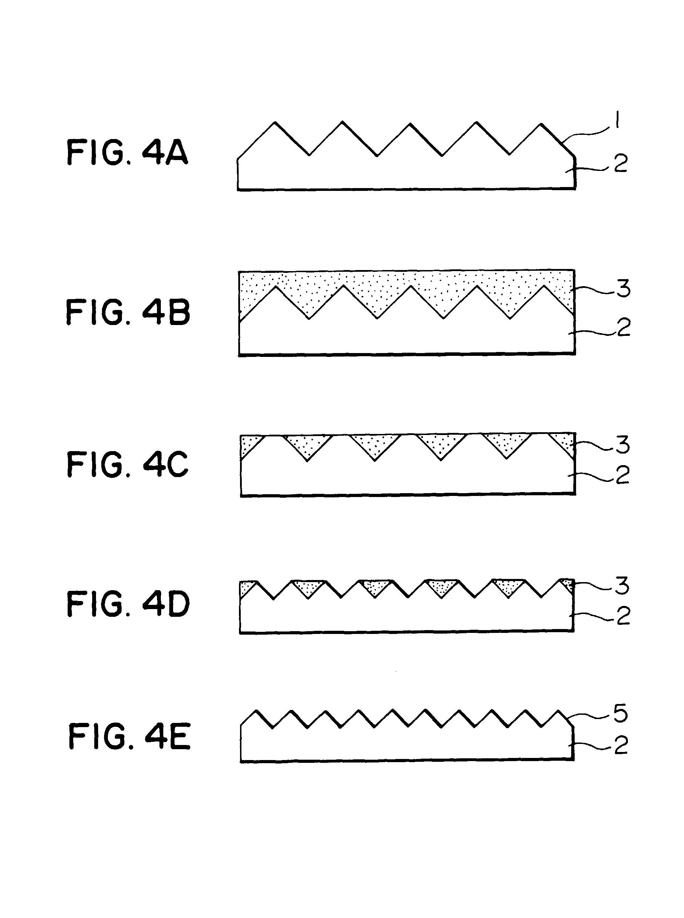

Figs. 4A-4E respectively show the steps of the first embodiment of a diffraction grating producing method according to the present invention. Initially, a first diffraction grating 1 having a pitch two times that of a desired diffraction grating is formed on a semiconductor substrate 2 using a holographic interferometry method explained by referring to Figs. 1A-1D (see Fig. 4A). The details are as follows:

The semiconductor substrate 2 is cleaned by a surface active agent, and then is cleaned by an ultrasonic means two or three times using an organic solvent. Thereafter, the substrate 2 is heat-treated at a temperature of 200°C for thirty (30) minutes by drying it with N₂ blow. Then, a photoresist layer for the two-beam interference exposure (this photoresist is made by diluting a trade name AZ-1350J: produced by Hoechst Inc. to a desired concentration) is applied over the substrate 2. This substrate 2 with the photoresist is dried at a temperature of 80°C. The thickness of the photoresist or etching mask layer is prpperly set to 600 Å -800 Å.

The photoresist layer is then exposed to two light beams respectively entering at an incident angle θ corresponding to a desired period Λ, according to the two-beam interference exposure method using an He-Cd laser (wavelength: λ =325 nm). The photoresist layer is then developed with a developer of AZ series. As a result, a resist pattern (diffraction grating) is formed corresponding to a photosensitivity degree resulting from the intensity distribution of interference fringes caused by the interference exposure.

The semiconductor substrate 2 is etched with the resist pattern being an etching mask, by using, for example, etching liquid of H₃PO₄ series or NH₄OH series in the case of a wet etching, or gas of Cl₂ series in the case of a dry etching. The first diffraction grating 1 is obtained on the substrate 2 by removing the etching mask layer (see Fig. 4A).

Next, a second diffraction grating 5 having a pitch half that of the first diffraction grating 1 is fabricated. First, the semiconductor substrate 2 having the first diffraction grating 1 thereon is cleaned by the ultrasonic means two or three times using an organic solvent. Thereafter this substrate 2 is heat treated by drying at a temperature of 90°C with N₂ blow for thirty (30) minutes. Then, as an etching mask layer 3. photoresist (this is made by diluting a trade name AZ-1350J: produced by Hoechst Inc. to a desired concentration) is applied over the substrate 2. This substrate is dried at a temperature of 80°C for twenty (20) minutes (see Fig. 4B). Next, the etching is conducted for an appropriate time using the reactive ion beam etching process (RIBE) with Cl₂ gas. Conditions at this time are such that a arrival vacuum degree is 2 × 10⁻⁶ Torr, a Cl₂ flow is equal to or less than 15 SCCM, an etching pressure is 7.5 × 10⁻⁴ Torr∼1.5 × 10⁻³ Torr and an ion drawing voltage is 400 V. Under the etching conditions, the etch rate of the semiconductor substrate 2 is 1600 Å/min, and a selective ratio thereof relative to the resist mask 3 (etching mask) is about 4:1.

In the etching process, the etching mask layer 3 formed over the entire substrate 2 is initially etched to be thinned (see Figs. 4B and 4C). When the semiconductor substrate 2 thereunder is exposed, a rate-determination step is caused at the boundary between the etching mask layer 3 and the semiconductor substrate 2 due to the selective ratio or difference in the etching rates between the etching mask layer 3 and the semiconductor substrate 2. Thus, a specific etching process advances (see Figs. 4C and 4D). Consequently, the second diffraction grating 5 is formed having a pitch half of that of the initially produced first diffraction grating 1.

Finally, the remaining etching mask layer 3 is removed, and the desired diffraction grating 5 is obtained on the semiconductor substrate 2 (see. Fig. 4E).

As described in the foregoing, in this embodiment, a photoresist is coated over all of the first diffraction grating 1 obtained by the conventional holographic interferometry method. And the dry etching is directly performed to this grating 1 without any exposure and development treatments. By such a simple process, the diffraction grating having a fine pitch (half of that of the initially formed diffraction grating) can be stably obtained with a good accuracy.

Thus, a diffraction grating (pitch: Λ = 1300 Å) can be accurately and stably produced in short wavelength ( λ =0.8 µm) DFB and DBR semiconductor lasers and the like. When such diffraction grating is used in optical devices, various advantages can be obtained compared with devices having a second order diffraction grating. For example, in the DFB and DBR lasers, an enhanced light coupling efficiency can be attained between the active region and the diffraction grating region, and the radiation loss and higher order scattering loss can be reduced. As a result, the oscillation threshold value is lowered.

The present invention is not limited to configurations of the above-discussed embodiment. For example, while the shape of the first diffraction grating 1 is triangular in the embodiment, rectangular and trapezoidal shapes and the like may be adopted. The. shape may be determined according to the specification of the device. In such cases, the producing process is substantially the same as the one described above. Moreover, in the embodiment, a photoresist is used as the etching mask layer 3 for the second diffraction grating 5. However, for example, oxide and nitride layers of SiO₂ and Si₃N₄ or metal materials may be used in place of the photoresist. In summary, the appropriate material need only be determined according to etching conditions at the time of the dry etching. As for the substrate, glass, optical glass and the like may be used as well as the semiconductor substrate 2.

Furthermore, while the RIBE method is used at the time of the etching of the second diffraction grating 5 in the embodiment, the sputtering etching, ion milling, reactive ion etching (RIE) and the like may be similarly utilized. Also, with respect to the etching gas, it is not limited to Cl₂ gas, as any suitable gas may be selected in accordance with materials of the substrate and the etching mask layer.

According to the present invention, after a first diffraction grating has been formed by the conventional method, this grating is coated overall with material different from that of the grating, such as photoresist. A second diffraction grating having a fine pitch is produced by directly etching the first diffraction grating coated with the different material, utilizing dry etching and the like. Therefore, the process can be shortened, and the stability of pattern accuracy as well as the yield can be improved. Thus, a diffraction grating having a very fine pitch can be achieved.

Consequently, characteristics of visible light DFB and DBR lasers and the like are improved. Moreover, characteristics of devices such as lasers, filters and the like which use a first order diffraction grating can be enhanced.

While the present invention has been described with respect to what is presently considered to be the preferred embodiments, it is understood that the invention is not limited to the disclosed embodiments. The present invention is intended to cover various modifications and equivalent arrangements included within the scope of the appended claims.

## Claims

1. A method of producing a diffraction grating, comprising the step of:
- forming, on a substrate (2), a diffraction grating (1) having periodic projections and recesses of a first pitch;
- coating said first diffraction grating with a masking material (3) which is different from the material of said substrate (2), such that both the projections and the recesses are completely covered by the masking material;
- reducing the thickness of the masking material (3) by etching until the crest portions of the projections of the first diffraction grating are removed and the corresponding exposed sections of the surface of the substrate (2) are free from the masking material; and
- etching the exposed sections of the substrate, thereby producing a diffraction grating (5), the pitch of which is smaller than the first pitch,
**characterized** in that
- the reducing step and the etching step are performed simultaneously by overall dry etching, in that the materials used for the substrate (2) and for the masking material (3) are such that the etching rate of the substrate is greater than that of the masking material,
- in said coating step the masking material (3) on said first diffraction grating (1) is thicker on the recesses than on the projections, and
- the reducing step and the etching step are performed without including another process for exposing said projections of said first diffraction grating (1).

2. A method of producing a diffraction grating according to Claim 1, wherein said second pitch is half of said first pitch.

3. A method of producing a diffraction grating according to Claim 1, wherein said first diffraction grating forming step further comprises the steps of: coating said substrate with photoresist, interference-exposing the photoresist, and performing an etching with the interference-exposed photoresist being a mask, to form said first diffraction grating having said first pitch.

4. A method of producing a diffraction grating according to Claim 1, wherein said first diffraction grating has a triangular shape.

5. A method of producing a diffraction grating according to Claim 1, wherein said material comprises a photoresist.

6. A method of producing a diffraction grating according to Claim 1, wherein said material comprises an oxide.

7. A method of producing a diffraction grating according to Claim 1, wherein said material comprises a nitride.

8. A method of producing a diffraction grating according to Claim 1, wherein said material comprises a metal.

9. A method of producing a diffraction grating according to Claim 1, wherein said substrate comprises a semiconductor.

10. A method of producing a diffraction grating according to Claim 1, wherein said substrate comprises glass.

11. A method of producing a diffraction grating according to Claim 1, wherein said substrate comprises optical glass.

12. A method of producing a diffraction grating according to Claim 1, wherein a reactive ion beam etching is used in said dry etching step.

13. A method of producing a diffracting grating according to Claim 1, wherein a sputtering etching is used in said dry etching step.

14. A method of producing a diffraction grating according to Claim 1, wherein an ion milling is used in said dry etching step.

15. A method of producing a diffraction grating according to Claim 1, wherein a reactive ion etching is used in said dry etching step.

## Patentansprüche

1. Verfahren zur Herstellung eines Beugungsgitters, das die nachstehenden Schritte umfaßt:
- Herstellung eines Beugungsgitters (1) mit periodischen Vorsprüngen und Vertiefungen einer ersten Teilung auf einem Substrat (2);
- Beschichten des ersten Beugungsgitters mit einem Maskierungsmaterial (3), das sich von dem Material des Substrats (2) unterscheidet, so daß sowohl die Vorsprünge als auch die Vertiefungen vollständig von dem Maskierungsmaterial bedeckt werden;
- Verringern der Dicke des Maskierungsmaterials (3) durch Ätzen, solange bis die Kammbereiche der Vorsprünge des ersten Beugungsgitters entfernt sind und die entsprechenden ungeschützten Abschnitte der Oberfläche des Substrats (2) von dem Maskierungsmaterial befreit sind; und
- Ätzen der ungeschützten Abschnitte des Substrats, wodurch ein Beugungsgitter (5) hergestellt wird, dessen Teilung kleiner als die erste Teilung ist,
**dadurch gekennzeichnet, daß**
- der Schritt des Verringerns und der Ätzschritt gleichzeitig durch eine Trockenätzung der ganzen Fläche erfolgt, bei der die für das Substrat (2) und für das Maskierungsmaterial (3) verwendeten Materialien so beschaffen sind, daß die Ätzgeschwindigkeit des Substrats größer als die des Maskierungsmaterials ist,
- in dem Beschichtungsschritt das Maskierungsmaterial (3) auf dem ersten Beugungsgitter (1) auf den Vertiefungen dicker als auf den Vorsprüngen ist, und
- der Schritt des Verringerns und der Ätzschritt ohne Einschluß eines anderen Verfahrens zur Freilegung der Vorsprünge des ersten Beugungsgitters (1) erfolgen.

2. Verfahren zur Herstellung eines Beugungsgitters nach Anspruch 1,
**dadurch gekennzeichnet, daß**
die zweite Teilung die Hälfte der ersten Teilung beträgt.

3. Verfahren zur Herstellung eines Beugungsgitters nach Anspruch 1,
**dadurch gekennzeichnet, daß**
der Schritt der Herstellung des ersten Beugungsgitters ferner die nachstehenden Schritte umfaßt: Beschichtung des Substrats mit einem Photoresist, Interferenzbelichtung des Photoresists, und Durchführung einer Ätzung mit dem interferenzbelichteten Photoresist als Maske, um das erste Beugungsgitter mit der ersten Teilung herzustellen.

4. Verfahren zur Herstellung eines Beugungsgitters nach Anspruch 1,
**dadurch gekennzeichnet, daß**
das erste Beugungsgitter die Form eines Dreiecks aufweist.

5. Verfahren zur Herstellung eines Beugungsgitters nach Anspruch 1,
**dadurch gekennzeichnet, daß**
das Material ein Photoresist umfaßt.

6. Verfahren zur Herstellung eines Beugungsgitters nach Anspruch 1,
**dadurch gekennzeichnet, daß**
das Material ein Oxid umfaßt.

7. Verfahren zur Herstellung eines Beugungsgitters nach Anspruch 1,
**dadurch gekennzeichnet, daß**
das Material ein Nitrid umfaßt.

8. Verfahren zur Herstellung eines Beugungsgitters nach Anspruch 1,
**dadurch gekennzeichnet, daß**
das Material ein Metall umfaßt.

9. Verfahren zur Herstellung eines Beugungsgitters nach Anspruch 1,
**dadurch gekennzeichnet, daß**
das Substrat einen Halbleiter umfaßt.

10. Verfahren zur Herstellung eines Beugungsgitters nach Anspruch 1,
**dadurch gekennzeichnet, daß**
das Substrat Glas umfaßt.

11. Verfahren zur Herstellung eines Beugungsgitters nach Anspruch 1,
**dadurch gekennzeichnet, daß**
das Substrat optisches Glas umfaßt.

12. Verfahren zur Herstellung eines Beugungsgitters nach Anspruch 1,
**dadurch gekennzeichnet, daß**
in dem Trockenätzschritt ein Reaktives Ionenstrahlätzen angewandt wird.

13. Verfahren zur Herstellung eines Beugungsgitters nach Anspruch 1,
**dadurch gekennzeichnet, daß**
in dem Trockenätzschritt ein Sputterätzen angewandt wird.

14. Verfahren zur Herstellung eines Beugungsgitters nach Anspruch 1,
**dadurch gekennzeichnet, daß**
in dem Trockenätzschritt ein Ionenstrahlätzen (ion milling) angewandt wird.

15. Verfahren zur Herstellung eines Beugungsgitters nach Anspruch 1,
**dadurch gekennzeichnet, daß**
in dem Trockenätzschritt ein Reaktives Ionenätzen angewandt wird.

## Revendications

1. Procédé de production d'un réseau de diffraction comprenant les étapes qui consistent :
- à former, sur un substrat (2), un réseau (1) de diffraction ayant des protubérances et des évidements périodiques d'un premier pas;
- à revêtir ledit premier réseau de diffraction d'un matériau (3) de masquage qui est différent du matériau dudit substrat (2), de façon que les protubérances et les évidements soient tous entièrement recouverts par le matériau de masquage;
- à réduire l'épaisseur du matériau (3) de masquage par attaque chimique jusqu'à ce que les parties de crête des protubérances du réseau de diffraction soient retirées et que les sections exposées correspondantes de la surface du substrat (2) soient exemptes du matériau de masquage; et
- à attaquer chimiquement les sections exposées du substrat, afin de produire un réseau (5) de diffraction dont le pas est plus petit que le premier pas,
caractérisé en ce que
- l'étape de réduction et l'étape d'attaque chimique sont effectuées simultanément par une attaque à sec globale, en ce que les matériaux utilisés pour le substrat (2) et pour le matériau (3) de masquage sont tels que la vitesse d'attaque du substrat soit supérieure à celle du matériau de masquage,
- en ce que ladite étape d'application du matériau (3) de masquage sur ledit premier réseau (1) de diffraction a une plus grande épaisseur sur les évidements que sur les protubérances, et
- l'étape de réduction et l'étape d'attaque sont effectuées sans faire appel à un autre traitement d'exposition desdites protubérances dudit premier réseau (1) de diffraction.

2. Procédé de production d'un réseau de diffraction selon la revendication 1, dans lequel ledit second pas est la moitié dudit premier pas.

3. Procédé de production d'un réseau de diffraction selon la revendication 1, dans lequel ladite étape de formation du premier réseau de diffraction comprend en outre les étapes qui consistent : à revêtir ledit substrat d'un vernis photosensible, à exposer par interférence le vernis photosensible, et à effectuer une attaque en utilisant le vernis photosensible exposé par interférence comme masque, pour former ledit premier réseau de diffraction ayant ledit premier pas.

4. Procédé de production d'un réseau de diffraction selon la revendication 1, dans lequel ledit premier réseau de diffraction a une forme triangulaire.

5. Procédé de production d'un réseau de diffraction selon la revendication 1, dans lequel ledit matériau comprend un vernis photosensible.

6. Procédé de production d'un réseau de diffraction selon la revendication 1, dans lequel ledit matériau comprend un oxyde.

7. Procédé de production d'un réseau de diffraction selon la revendication 1, dans lequel ledit matériau comprend un nitrure.

8. Procédé de production d'un réseau de diffraction selon la revendication 1, dans lequel ledit matériau comprend un métal.

9. Procédé de production d'un réseau de diffraction selon la revendication 1, dans lequel ledit substrat comprend un semiconducteur.

10. Procédé de production d'un réseau de diffraction selon la revendication 1, dans lequel ledit substrat comprend un verre.

11. Procédé de production d'un réseau de diffraction selon la revendication 1, dans lequel ledit substrat comprend un verre optique.

12. Procédé de production d'un réseau de diffraction selon la revendication 1, dans lequel une attaque par faisceaux d'ions réactifs est utilisée lors de ladite étape d'attaque à sec.

13. Procédé de production d'un réseau de diffraction selon la revendication 1, dans lequel une attaque par pulvérisation cathodique est utilisée dans ladite étape d'attaque à sec.

14. Procédé de production d'un réseau de diffraction selon la revendication 1, dans lequel un usinage ionique est utilisé dans ladite étape d'attaque à sec.

15. Procédé de production d'un réseau de diffraction selon la revendication 1, dans lequel une attaque par ions réactifs est utilisée dans ladite étape d'attaque à sec.
